# EUROPEAN PATENT SPECIFICATION

(11) **EP 1 566 244 B1**
(45) Date of publication and mention of the grant of the patent: **08.04.2009**
(21) Application number: 04018798.1
(22) Date of filing: 07.08.2004
(51) Int. Cl.: B25J 9/10

(54) **Robot-guidance assembly for providing a precision motion of an object**
Roboter-Führungsvorrichtung zur präzisen Bewegung eines Gegenstandes
Guidage de robot pour assurer le mouvement précis d'un objet

(30) Priority: 20.02.2004 DE 102004008289
(43) Date of publication of application: 24.08.2005
(73) Proprietor: Integrated Dynamics Engineering GmbH, 65479 Raunheim (DE)
(72) Inventor: Tillmann, Ralf Dr., 68309 Mannheim (DE)
(74) Representative: Herden, Andreas F.

(56) References cited:
- US-A- 4 523 100
- US-A- 6 109 677
- US-A1- 2003 218 456

## Description

### BACKGROUND OF THE INVENTION.

### 1. Field of the Invention.

The invention relates to a robot-guidance assembly according to the preamble of claim 1 for providing a precision motion of an object.

Such an assembly is known e.g. from US-A-2003 218 456. The invention also relates to an inspection tool comprising such an assembly for inspecting a surface of an object, and to a method carried out with such an inspection tool.

### 2. Description of related art.

Semiconductor wafers are produced by complicated multi-step processes in a clean room environment. The production of sophisticated electronic chips from wafers may include as many as about 150 steps. Technologies in the submicron range are very delicate, and there always exists a chance of error or malfunction at each of the many stages, which ought to be discerned as soon as possible.

Throughout the semiconductor processing precision motion systems, e.g. positioning stages, are used, for example in wafer metrology tools like microscopes.

US-A-2003 218 456 describes a large substrate test system. A system and method for testing substrates is generally provided. In one embodiment, a test system for testing a substrate includes a load lock chamber, a transfer chamber and a test station. The load lock chamber and the test station are disposed on top of one another and coupled to the transfer chamber. The transfer chamber includes a robot with an end effector adapted to transfer a substrate between the load lock chamber, which is at a first elevation, and the test station, which is at a second elevation whereby the horizontal movement of the end effector is guided upon entry into the test station by grooves provided in a support hoop.

The common approach is to use a self contained, i.e. a functionally independent, x-y-motion system within the metrology tool, which has a chuck to which the wafer is transferred from the wafer handling system that includes a robot for transporting the wafer from one to the next production or inspection stage.

This results in the typical workflow:
1. The x-y-motion system moves to a load position, at which the wafer is
2. transferred from the robot on to the chuck of the x-y-motion system, after this the wafer is moved into the metrology tool and the
3. metrology or inspection process is carried out, in the following
4. the motion system moves the wafer back to the load position, where it is
5. transferred to the handling system or robot.

Looking at this flow from a systems standpoint one can see that there are two redundant motion systems, i.e. the handling system and the x-y-motion system of the metrology tool. In this kind of handling system the throughput depends strongly on the time the metrology tool has to wait for material handed over by the robot handler. Moreover, it should be noted that in the state of the art systems two separated motion systems are necessary for the handling and the metrology process.

These and other disadvantages have lead to the objects of the present invention, especially to simplify the known motion systems, and to increase the throughput of the production and/or inspection processes

### SUMMARY OF THE INVENTION.

The inventive solution is obtained by the assembly defined in claim 1. Further refinements and advantageous developments are part of the respective dependent claims. The invention also encompasses an inspection tool according to claim 13 and a method according to claim 14.

Thus far, in general, the invention is a robot-guidance assembly for providing a precision motion of an object, especially for providing a precision motion of a disklike member like a wafer, comprising robot means including at least one robot arm encompassing a free end and a fixed end being attached to the robot means, wherein said robot is adapted to move said free end of said arm at least in one moving plane, whereby guiding means adapted to and provided for precisely guiding said free end of said arm in at least said plane is provided. Said guiding means comprises a mounting mechanism for removable mounting said end of said arm and/or end-effector means to said guiding means.

In this way, for the first time, the invention sets forth the possibility to use the robot that is present in every wafer handlingsystem as a motion system for metrology tools as well, canceling the need for an extra motion system within the metrology tool. In a highly advantageous manner, this cuts down costs and also reduces cycling time for a measurement of the wafer due to the time saved for the non-existing wafer transfer from the handling system to the metrology motion system. Additionally it should be noted that for the present invention various types of handling robots like scara or linear robots can be applied.

Depending on the motion system of the robot, i.e. whether the robot has a polar co-ordinate system with a linear-radius- or r-moving-axis and a rotary-stage- or theta-moving-axis (r-theta), or whether it has a Cartesian co-ordinate system for a x-y-motion, it is provided that the guiding means favorably comprises one or two or even more precision moving or guiding axis. Thus it is guaranteed that the end of the robot arm or an end-effector means, which is attached to the end of the robot arm for accepting and holding the object or the disklike member at this end, is forced to move exactly along the respective axis, whereby, otherwise, the movement of the end-effector would fail the precision requirements for a scan inside, for instance, a microscope. In case of a r-theta-system generally one axis of motion is sufficient. When a x-y-motion-system is used two stacked linear axis are provided. The direction of motion for these axis is off-set by 90° giving a Cartesian co-ordinate system.

The choice of the motion system has also an impact on the selection of an appropriate end-effector means. Therefore, for instance, according to the invention, if, for example, a scara robot with a r-theta motion system is used, it is provided that the end-effector favorably has the capability to rotate the disklike member about its rotary axis. Such an end-effector is disclosed by WO 02/02282 A1.

Thus, highly advantageous, the end-effector replaces the movement of a separate rotary stage, which would be necessary otherwise. Moreover, this allows that the dependency of the angular orientation of the wrist joint and thus that of the end-effector of a scara robot can be cancelled quite easily. The mentioned dependency originates from the fact that the end-effectors of those robots are always oriented radially with respect to the theta axis.

Preferably, the mounting mechanism comprises a pneumatic lock which is arranged on one side or upper side of a stage, whereas the other side of the stage comprises sliding means. The sliding means can include bearings of any known kind, e.g. crossed roller bearing, profiled guides with recirculating ball carriages or even air bearings. These sliding means co-operate with rails arranged on a mounting member for the purpose of precisely guiding the stage, and thus the end of the robot arm or end-effector.

Further more, the inventive mounting mechanism, if at wish, encompasses a rotational degree of freedom, that allows to rotate the end-effector into a locking position, which also opens up the possibility to cancel the dependency of the angular orientation of the wrist joint and thus that of the end-effector as described above

According to a preferred embodiment of the invention the inventive guiding means passively guides said free end of said robot arm. This means that only the robot means provides the driving force for the movement of the guided free end of the robot arm and/or the end-effector, respectively. This includes that merely the motors and the position feed back elements of the robot are used for the motion process.

For a even further refinement of the motion system of the inventive assembly the guiding means comprises additional encoders for a secondary positioning feedback system. Thus, by using a closed-loop control of the stage position, there is no chance that the stage will become lost. Precision motion system in this regard means that the stage is guided in a tolerance band of 2 to 3µm per 100mm.

Of course, it is possible that the guiding means itself includes an internal drive. In this case, for example, the robot can be used as a motion controller using its internal feedback system for to close the position control loop. Advantageously, thus there is no need for an additional interface to the process controller. Moreover, it simplifies the control programming since the robot and the metrology motion system use the same control language.

Moreover, according to an additional further development of the invention, it is provided that the guiding means includes a self contained motion system, as it is known from XYZ-stages of microscopes, wherein means are given which allow, especially a mechanical uncoupling of the end-effector completely from the robot arm. It should be noted that also in this embodiment the robot plays an important roll. In this respected, for instance, the robot can still supply the rotating movement of the disklike member or wafer on an appropriate end-effector (see above) and the control electronics, thus reducing costs and simplifying the system design. The energy supply however is provided via the locking mechanism.

### BRIEF DESCRIPTION OF THE DRAWING.

The invention together with additional features and advantages thereof will be best understood from the following description.

It is shown:
- Fig. 1: an over view of the essential parts of the inventive robot guidance assembly.
- Fig. 2: a sectional view A-A (see Fig. 4) of one embodiment an inventive end-effector lock or locking mechanism.
- Fig. 3: a sectional view of the position fixing element use by the locking mechanism according to Fig. 2.
- Fig. 4: a top view of the locking mechanism of Figures 2 and 5.
- Fig. 5: sectionals views B-B (see Fig. 4) of the embodiment of Fig. 2 of the inventive locking mechanism, whereby Fig. 5A shows the mechanism in the locked position and Fig. 5B shows it in the unlocked position.
- Fig. 6: shows the inventive assembly built in a rack.

### DETAILED DESCRIPTION OF THE DRAWINGS.

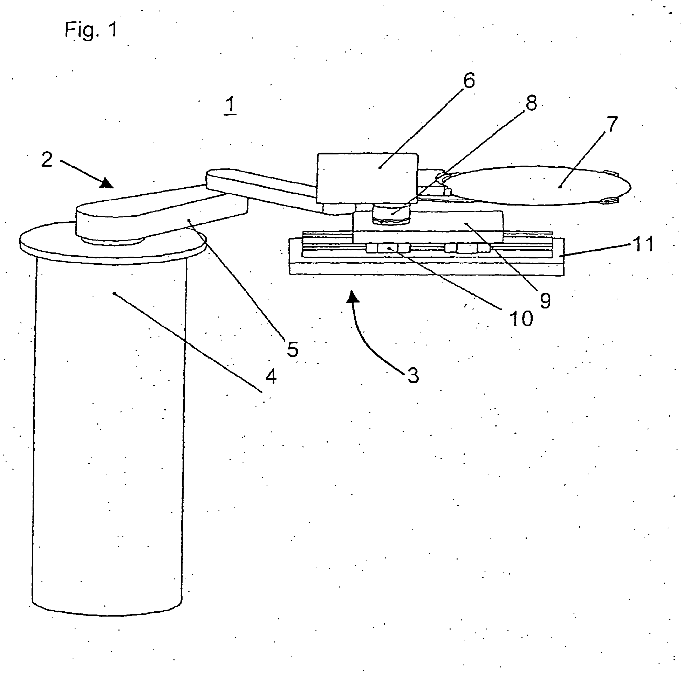

Figure 1 shows an example of one embodiment of the inventive robot-guidance assembly 1. The assembly comprises two main components, namely a robot body 2 and guiding apparatus or means 3. The robot 2 shown is a SCARA type robot. It includes a body 4, a robot arm 5 and an end-effector 6 which holds a wafer 7. The robot body 2 includes motor drives for driving the robot arm 5 and the end-effector 6, and a robot controller, both not shown in Fig. 1. End-effector 6 is used to grab and hold wafer 7, and robotic arm 5 including various motors and mechanical mechanisms not shown in the Figures, moves end-effector 6 and the wafer that it holds within its grasp 7 from one station to another in the inspection or production process.

For the handling of single wafer in an Semiconductor Fabric robot 2 typically has three positioning axis's. One axis to move the wafer 7 with its arm vertically up and down, called z-axis, and at least two other axis's to move it horizontally from one station to another in the production process, typically a Theta and an R-axis. These types of robots are well known in the art and are not further described hereinafter in detail.

According to the embodiment of Fig. 1 the end-effector 6 is attached to the guiding apparatus 3 via and end-effector lock 8. The guiding apparatus to this end is a linear guide which is part of a metrology tool (not shown in Fig. 1). It comprises a stage 9 to which at its top the mating partner of the end-effector lock 8 is attached to. At the lower side of the stage linear slides 10 are provided. These slides 10, as a moving and guiding partner, co-operate with a pair of parallel running rails 12 which are arranged on a plate 11. The slides 10 can be of any known kind including crossed roller bearings, profiled guides with recirculating ball carriages or even air bearings. From the functional point of view the linear guide 3 shown in Fig. 1 is a passive guide, which forces the end-effector 6 on a straight line providing a precise robot 2 driven linear movement of the end-effector 6 inside a metrology tool like a microscope (not shown), whereby it is guaranteed that the surface of the wafer 7 during movement remains in a defined orientation in space.

Yet for a complete scan, i.e. for to reach every point on the wafer surface with respect to a stationary outside view point inside the metrology tool a single linear motion is not sufficient. According to the invention with respect to the embodiment displayed in Fig. 1 this problem is solved by using an end-effector 6 with the capability to rotate the wafer 7 grasped about the symmetry axis of the wafer which includes a 90° angle with the surface. Such an end-effector 6, for instance, is disclosed in the WO 02/02282 A1. The application of such an end-effector 6 even further has the advantage that there is no need any longer for a stand alone pre-aligner because the end-effector 6 is able to pre-align the wafer while moving it from one station to another.

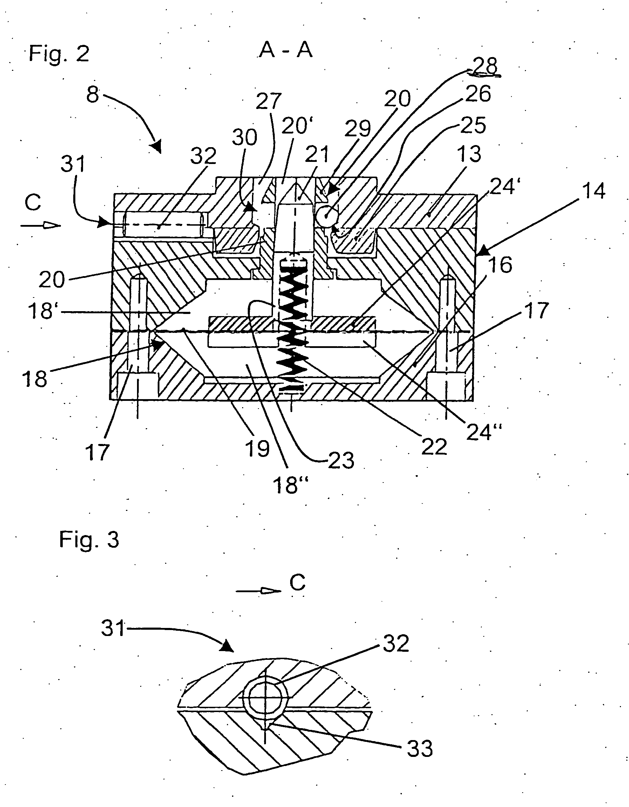

Another essential part of the inventive assembly or guiding means 3 is the end-effector lock or locking mechanism 8 as already mentioned above. A detailed view of a possible embodiment according to the invention can be seen in Fig. 2. The locking mechanism 8 is a kinematic mount in form of a pneumatic lock which removably combines the stage 9 with the end-effector 6, thereby interlocking the end-effector 6 with the stage 9 by charging the pneumatic lock with negative pressure. A negative pressure lock is especially favorable in a clean room environment.

The locking mechanism 8 includes three essential parts, namely a stage plate 13 which is affixed to the stage 9, a locking member 14 comprising the major parts of the lock 8, which will be described in detail below. The locking member 14 is attached to the end-effector plate 16 which is lodged to the underside of the end-effector housing 15 (Fig. 1), whereby the mating surfaces are supposed to be precision flat. The end-effector plate 16 is fixed to the locking member 14 via screws which are to be inserted into screw-holes 17 extending through the end-effector plate and which find their end in pocket holes of the locking member 14.

The locking member together with the end-effector plate form a hollow member 18. The hollow member 18 is divided into an upper and an lower chamber 18', 18" by the membrane 19. The membrane 19 air-seals the two chambers from one another. At the center of the locking member a hollow guide 20 is provided. The hollow guide 20 is part of the locking member and comprises a through hole 20' which moveably accommodates cone locking pin 21. At its lower end pin 21 pushes through membrane 19 and comprises plates 24' and 24", that forms hard center 24, which sandwiches membrane 19. In this respect plate 24" lies inside chamber 18" and plate 24' inside chamber 18'.

In its lower part cone locking pin 21 includes a blind hole 23, wherein the upper part of the spring 22 is brought in. Spring 22 attaches the bottom of blind hole 23 and is supported by the end-effector plate 16.. In case the locking mechanism is not charged with negative pressure spring 22 holds the cone locking pin in an equilibrium position; as it is shown in Fig. 2.

Hollow guide 20, at the upper end of locking member 14, is surrounded by locking ring 25 which is embedded in a groove that is brought in at the top side of locking member 14. The thickness of the ring 25 levels with the upper side of locking member 14 with the exception that at the inner side of locking ring 25 a ring nose or edge 26 is provided which extends out of the surface. The outer diameter of edge 26 is the same as the inner diameter of stage plate hole 27. Thus edge 26 centers stage plate 13 into the locking position of the locking mechanism 8. Stage plate hole 27 together with cage members 29 of hollow guide 20 form cages for locking balls 28. For this embodiment, all together, there are three locking balls at a distance of 120°.

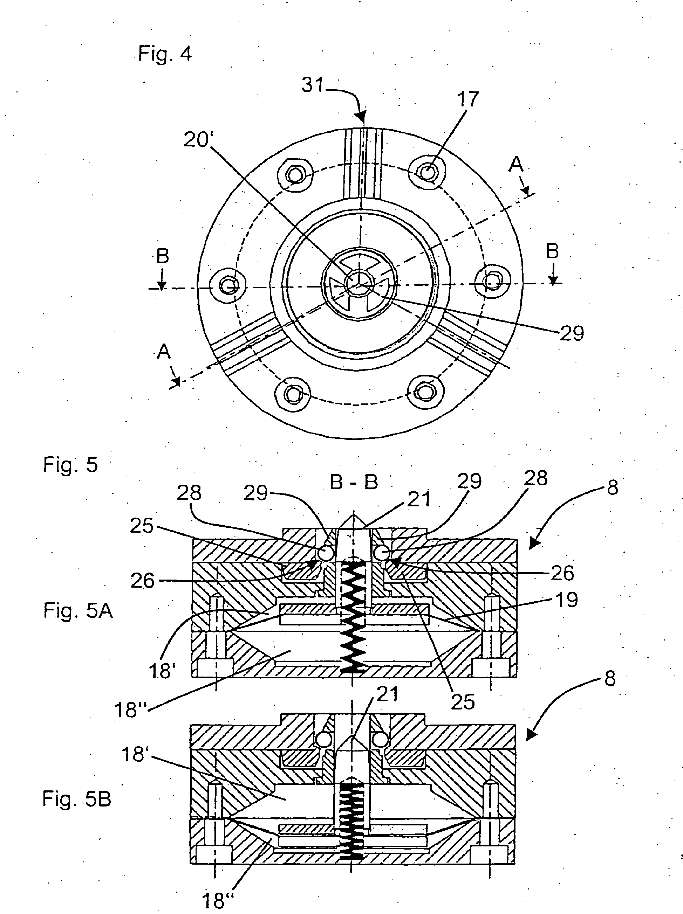

Moreover a position fixing mechanism 31 is provided. It comprises three position fixing elements. These elements 31 are arranged at the outer ring of locking member 14 (see Fig. 4) on its upper side, and are thus sandwiched between the upper side of locking member 14 and stage plate 13. The position fixing elements include blind holes, wherein pins 32 are inserted. The blind holes are formed by key notches 33 in the upper surface of locking member 14 at a distance of 120° (see Fig. 4), whereby the orientation of the notches is the same as that of locking balls 28 or cage members 29, and by channels within the lower side of stage plate 13, whereby these channels are arranged next to notches 33. Functionally, it is the purpose of the position fixing mechanism 31 to provide a defined orientation between the locking member 14 and the stage plate 13 in the assembled state of the inventive locking mechanism 8.

With regard to the function of the inventive locking mechanism 8 it is now referred to Figs 5A and 5B. Fig. 5A displays lock 8 in its locked position. In this case chamber 18" is pressurized. Thus an upward movement of cone locking pin 21 is achieved. In its up position the cone of cone locking pin 21 pushes cage members 29 aside. This in turn presses locking balls 28 down onto edge 26 of locking ring 25, whereby in this way stage plate 13 is locked to locking member 14.

The other way round is shown in Fig. 5B. Therein it can be seen that it is not chamber 18" but chamber 18' that is charged with negative pressure, thereby cone locking pin 21 is pushed down and opens the lock 8.

The inventive locking mechanism favorable allows to mount the end-effector 6 into a repeatable position, as well as an exactly repeatable orientation in space, thus guaranteeing that the wafer surface 7 is always parallel to the direction of the linear guide. Of course, the invention is not restrict to pneumatic locks as described above but can be also of a electro mechanic or magnetic kind. Note that even gravity could be sufficient.

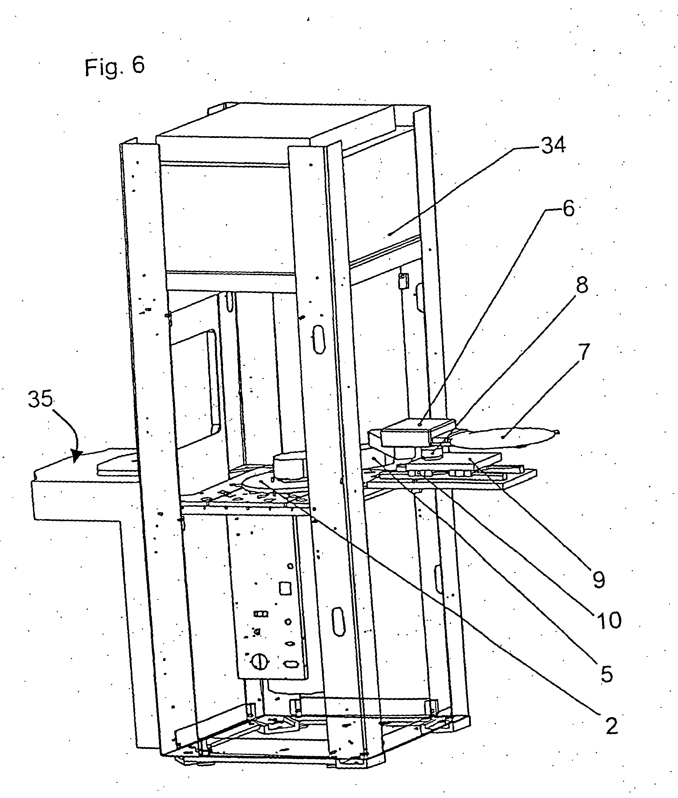

Fig. 6 shows the inventive assembly build in a rack 34. Rack 34 comprises on its front a Load Port for FOUP's, i.e. a front opening unified pod 35, and on its back the inventive guidance 3 for precisely guiding the end of robot arm 5 and the end-effector 6, respectively. Thus far, the inventive guidance 3 replaces a conventional XY-stage on which normally robot 2 has to place wafer 4 for any kind of purpose. Of course it could be provided that the rack 34 as a whole or at least the inventive guidance 3 are vibration-isolated.

## Claims

1. A robot-guidance assembly (1) for providing a precision motion of an object, especially for providing a precision motion of a disklike member like a wafer (7), comprising robot means (2) including at least one robot arm (5) encompassing a free end and a fixed end being attached to the robot means (2), wherein said robot (2) is adapted to move said free end of said arm (5) at least in one moving plane, wherein the assembly further comprises guiding means (3) adapted to and provided for precisely guiding said free end of said arm (5) in at least said plane, **characterized in that** said guiding means (3) comprises a mounting mechanism for removably mounting said end of said arm (5) and/or end-effector means (6) to said guiding means (3).

2. The assembly according to claim 1, wherein said guiding means (3) comprises at least one guiding axis.

3. The assembly according to claims 1 or 2 , wherein the robot arm (5), at its free end, encompasses said end-effector means (6) for accepting and holding the object or the disklike member.

4. The assembly according to claim 3, wherein said end-effector means (6) is adapted to rotate the disklike member about an axis which is perpendicular to its surface and goes through its midpoint.

5. The assembly according to claim 1, wherein said mounting mechanism is adapted to rotate said end-effector means (6) into a locking position.

6. The assembly according to one of the preceding claims, wherein said guiding means (3) comprises a stage (9) including two sides, whereby the mounting mechanism is attached to one of said sides.

7. The assembly according to claim 6, wherein said stage (9) comprises sliding means (10) at its lower side.

8. The assembly according to one of the preceding claims, wherein said guiding means (3) comprises a mounting member including guide rails (12) co-operating with said sliding means (10).

9. The assembly according to one of the preceding claim, wherein said guiding means (3) passively guides said free end of said robot arm (5).

10. The assembly according to one of the preceding claims, wherein said guiding means (3) comprises encoders for a positioning feedback system.

11. The assembly according to one of the preceding claims, wherein said guiding means (3) includes an internal drive.

12. The assembly according to one of the preceding claims, wherein said end-effector means (6) is uncouplable mounted to said free end of said robot arm (5).

13. Inspection Tool for inspecting a surface of an object, especially for inspecting a wafer (7) surface, comprising an inspection device for inspecting the object, and a robot-guidance assembly as defined according to one of the preceding claims for positioning and aligning the object within the inspection device.

14. A method carried out with an inspection tool according to claim 13, wherein an end-effector (6) of a robot (2), holding a disklike member with a surface, at a defined position, is removably attached to guiding means (3) comprising at least one motion axis which, on a driven movement of said guiding means (3), lead to a precision movement of said end-effector (6) to an inspection tool and inside of the inspection tool along said at least one motion axis, whereby on the basis of this motion the surface of the disklike member can be scanned.

15. The method according to claim 14, wherein after inspection the end-effector (6) is moved back to the defined position , whereby in that position the end-effector (6) is detached from the guiding means (3).

## Patentansprüche

1. Roboter-Führungsanordnung (1) zum Bereitstellen einer Präzisionsbewegung für ein Objekt, insbesondere zum Bereitstellen einer Präzisionsbewegung für ein scheibenartiges Element wie einen Wafer (7), welche eine Robotereinrichtung (2) mit zumindest einem Roboterarm (5) mit einem freien Ende und einem festen Ende, der an der Robotereinrichtung (2) befestigt ist, umfasst, wobei der Roboter (2) dafür ausgelegt ist, das freie Ende des Arms in zumindest einer Bewegungsebene zu bewegen, wobei die Anordnung ferner Führungsmittel (3) umfasst, die dafür ausgelegt und vorgesehen sind, das freie Ende des Arms (5) in der zumindest einen Ebene präzise zu führen, **dadurch gekennzeichnet, dass** die Führungsmittel (3) einen Montagemechanismus zum entfernbaren Montieren des Endes des Arms (5) und/oder eines Endeffektormittels (6) an den Führungsmitteln (3) umfassen.

2. Vorrichtung nach Anspruch 1, bei welcher die Führungsmittel (3) zumindest eine Führungsachse aufweisen.

3. Vorrichtung nach Anspruch 1 oder 2, bei welcher der Roboterarm (5) an seinem freien Ende das Endeffektormittel (6) zum Aufnehmen und Halten des Objekts oder des scheibenartigen Elements umfasst.

4. Vorrichtung nach Anspruch 3, bei welcher das Endeffektormittel (6) dafür ausgelegt ist, das scheibenartige Element um eine Achse zu drehen, die senkrecht zu dessen Oberfläche und durch dessen Mittelpunkt verläuft.

5. Vorrichtung nach Anspruch 1, bei welcher der Montagemechanismus dafür ausgelegt ist, das Endeffektormittel (6) in eine Verriegelungsstellung zu drehen.

6. Vorrichtung nach einem der vorhergehenden Ansprüche, bei welcher die Führungsmittel (3) eine Stufe (9) mit zwei Seiten umfassen, wobei der Montagemechanismus an einer der Seiten angebracht ist.

7. Vorrichtung nach Anspruch 6, bei welcher die Stufe (9) Verschiebungsmittel (10) an ihrer Unterseite umfasst.

8. Vorrichtung nach einem der vorhergehenden Ansprüche, bei welcher die Führungsmittel (3) ein Montagelement mit Führungsschienen (12) umfassen, das mit den Verschiebungsmitteln zusammenwirkt.

9. Vorrichtung nach einem der vorhergehenden Ansprüche, bei welcher die Führungsmittel (3) das freie Ende des Roboterarms (5) passiv führen.

10. Vorrichtung nach einem der vorhergehenden Ansprüche, bei welcher die Führungsmittel (3) Codierer für ein Positionierungsrückkopplungssystem umfassen.

11. Vorrichtung nach einem der vorhergehenden Ansprüche, bei welcher die Führungsmittel (3) einen internen Antrieb umfassen.

12. Vorrichtung nach einem der vorhergehenden Ansprüche, bei welcher das Endeffektormittel (6) entkoppelbar an dem freien Ende des Roboterarms (5) montiert ist.

13. Inspektionswerkzeug zur Inspektion einer Oberfläche eines Objekts, insbesondere zur Inspektion einer Oberfläche eines Wafers (7), welches eine Inspektionsvorrichtung zur Inspektion des Objekts sowie eine Roboter-Führungsanordnung wie gemäß einem der vorhergehenden Ansprüche definiert zum Positionieren und Ausrichten des Objekts in der Inspektionsvorrichtung umfasst.

14. Verfahren, das mit einem Inspektionswerkzeug entsprechend Anspruch 13 ausgeführt wird, wobei ein Endeffektor (6) eines Roboters (2), der ein scheibenartiges Element mit einer Oberfläche an einer definierten Position hält, entfernbar an Führungsmitteln (3) angebracht ist, die zumindest eine Bewegungsachse aufweisen, welche bei einer angetriebenen Bewegung der Führungsmittel (3) zu einer Präzisionsbewegung des Endeffektors (6) zu einem Inspektionswerkzeug und im Inneren des Inspektionswerkzeugs entlang der zumindest einen Bewegungsachse führt, wobei auf Grundlage dieser Bewegung die Oberfläche des scheibenartigen Elements abgescannt werden kann.

15. Verfahren nach Anspruch 14, bei welchem der Endeffektor (6) nach der Inspektion zurück an die definierte Position bewegt wird, wobei der Endeffektor (6) an dieser Position von den Führungsmitteln (3) gelöst wird.

## Revendications

1. Ensemble (1) de guidage de robot pour assurer un mouvement précis d'un objet, en particulier pour assurer un mouvement précis d'un élément analogue à un disque tel qu'une galette (7), comportant un moyen à robot (2) comprenant au moins un bras de robot (5) comprenant une extrémité libre et une extrémité fixe qui est reliée au moyen à robot (2), dans lequel ledit robot (2) est conçu pour déplacer ladite extrémité libre dudit bras (5) au moins dans un plan de déplacement, lequel ensemble comportant en outre un moyen de guidage (3) conçu et prévu pour guider avec précision ladite extrémité libre dudit bras (5) dans au moins ledit plan, **caractérisé en ce que** ledit moyen de guidage (3) comporte un mécanisme de montage pour le montage amovible de ladite extrémité dudit bras (5) et/ou d'un moyen terminal effecteur (6) sur ledit moyen de guidage (3).

2. Ensemble selon la revendication 1, dans lequel ledit moyen de guidage (3) comporte au moins un axe de guidage.

3. Ensemble selon la revendication 1 ou 2, dans lequel le bras de robot (5) comprend, à son extrémité libre, ledit moyen terminal effecteur (6) pour recevoir et maintenir l'objet ou l'élément analogue à un disque.

4. Ensemble selon la revendication 3, dans lequel ledit moyen terminal effecteur (6) est conçu pour faire tourner l'élément analogue à un disque autour d'un axe qui est perpendiculaire à sa surface et qui passe par son point milieu.

5. Ensemble selon la revendication 1, dans lequel ledit mécanisme de montage est conçu pour faire tourner ledit moyen terminal effecteur (6) jusque dans une position de verrouillage.

6. Ensemble selon l'une des revendications précédentes, dans lequel ledit moyen de guidage (3) comprend une platine (9) comprenant deux côtés, le mécanisme de montage étant fixé à l'un desdits côtés.

7. Ensemble selon la revendication 6, dans lequel ladite platine (9) comporte un moyen de glissement (10) à son côté inférieur.

8. Ensemble selon l'une des revendications précédentes, dans lequel ledit moyen de guidage (3) comporte un élément de montage comprenant des rails de guidage (12) coopérant avec ledit moyen de glissement (10).

9. Ensemble selon l'ùne des revendications précédentes, dans lequel ledit moyen de guidage (3) guide de façon passive ladite extrémité libre dudit bras de robot (5).

10. Ensemble selon l'une des revendications précédentes, dans lequel ledit moyen de guidage (3) comporte des codeurs pour un système de rétroaction de positionnement.

11. Ensemble selon l'une des revendications précédentes, dans lequel ledit moyen de guidage (3) comprend une transmission interne.

12. Ensemble selon l'une des revendications précédentes, dans lequel ledit moyen terminal effecteur (6) est monté sans possibilité d'accouplement sur ladite extrémité libre dudit bras de robot (5).

13. Outil d'examen pour examiner une surface d'un objet, en particulier pour examiner la surface d'une galette (7), comportant un dispositif d'examen pour examiner l'objet, et un ensemble de guidage de robot tel que défini dans l'une quelconque des revendications précédentes pour le positionnement et l'alignement de l'objet à l'intérieur du dispositif d'examen.

14. Procédé exécuté avec un outil d'examen selon la revendication 13, dans lequel un effecteur terminal (6) d'un robot (2), portant un élément analogue à un disque présentant une surface, dans une position définie, est relié de façon amovible à un moyen de guidage (3) comportant au moins un axe de mouvement qui, lors d'un mouvement entraîné dudit moyen de guidage (3), conduit à un mouvement de précision dudit effecteur terminal (6) jusqu'à un outil d'examen et à l'intérieur de l'outil d'examen le long dudit, au moins un, axe de mouvement, grâce à quoi, sur la base de ce mouvement, la surface de l'élément analogue à un disque peut être balayée.

15. Procédé selon la revendication 14, dans lequel après l'examen, l'effecteur terminal (6) est ramené vers la position définie, grâce à quoi, dans cette position, l'effecteur terminal (6) est séparé du moyen de guidage (3).
